# FASCICULE DE BREVET EUROPEEN

(11) **EP 2 937 311 B1**
(45) Date de publication et mention de la délivrance du brevet: **21.08.2019**
(21) Numéro de dépôt: 15164536.3
(22) Date de dépôt: 21.04.2015
(51) Int. Cl.: B81C 1/00

(54) **PROCÉDÉ DE FABRICATION D'UN COMPOSANT HORLOGER RENFORCÉ, COMPOSANT HORLOGER ET PIÈCE D'HORLOGERIE CORRESPONDANTS**
HERSTELLUNGSVERFAHREN EINER VERSTÄRKTEN UHRKOMPONENTE, ENTSPRECHENDE UHRKOMPONENTE UND ENTSPRECHENDE UHR
METHOD FOR MANUFACTURING A REINFORCED TIMEPIECE COMPONENT, CORRESPONDING TIMEPIECE COMPONENT AND TIMEPIECE

(30) Priorité: 25.04.2014 EP 14165968
(43) Date de publication de la demande: 28.10.2015
(73) Titulaire: ROLEX SA, 1211 Genève 26 (CH)
(72) Inventeur: Bossart, Richard, 1616 Attalens (CH); Favez, Denis, 1218 Le Grand-Saconnex (CH)
(74) Mandataire: Moinas & Savoye SARL

(56) Documents cités:
- WO-A1-03/007026
- US-A1- 2004 232 106
- NOELL W ET AL: "MEMS for a watches", MICRO ELECTRO MECHANICAL SYSTEMS, 2004. 17TH IEEE INTERNATIONAL CONFER ENCE ON. (MEMS) MAASTRICHT, NETHERLANDS 25-29 JAN. 2004, PISCATAWAY, NJ, USA,IEEE, US, 25 janvier 2004 (2004-01-25), pages 1-4, XP010767811, DOI: 10.1109/MEMS.2004.1290507 ISBN: 978-0-7803-8265-7
- PERRET A: "Le Silicium Comme Matériau Dans La Fabrication De Pièces Mécaniques", BULLETIN DE LA SOCIETE SUISSE DE CHRONOMETRIE, SSC, NEUCHATEL, CH, no. 38, 9 novembre 2001 (2001-11-09), pages 27-29, XP002460036,

## Description

L'invention concerne un procédé de fabrication d'un composant horloger à partir d'un matériau micro-usinable, par exemple du silicium.

Le silicium est un matériau présentant de multiples avantages pour la fabrication de composants horlogers. Il permet d'une part la fabrication simultanée d'un grand nombre de pièces de petite taille, avec une précision micrométrique. D'autre part, il a une faible densité et un caractère diamagnétique. Ce matériau présente toutefois un inconvénient : il ne possède pas, ou peu, de domaine de déformation plastique, ce qui en fait un matériau relativement fragile. Une sollicitation mécanique ou un choc peuvent conduire à une rupture du composant. La manipulation des composants horlogers en silicium, notamment lors de leur fabrication et de leur montage, s'avère donc particulièrement délicate.

La fragilité des composants horlogers en silicium est accentuée par leur découpage dans un substrat de silicium, généralement réalisé par une technique de gravure profonde, par exemple par gravure réactive ionique profonde DRIE (de l'anglais « *Deep Reactive Ion Etching* »). Une spécificité de ce type de gravure est de former des ouvertures ayant des flancs légèrement ridés qui présentent en surface des défauts de planéité sous la forme de vaguelettes (en anglais « *scalloping* »). Il en résulte une certaine rugosité des flancs gravés qui affaiblit la résistance mécanique du composant. En outre, les défauts de planéité peuvent générer des amorces de fissure, notamment en cas de sollicitation mécanique, et mener à la casse du composant.

Pour améliorer les propriétés mécaniques des composants horlogers en silicium, plusieurs approches ont déjà été proposées.

Une première approche, décrite dans le document EP2277822, consiste à former une couche d'oxyde de silicium par oxydation thermique du silicium à une température comprise entre 900°C et 1200°C. La couche d'oxyde formée résulte d'une conversion du silicium en surface du composant en oxyde de silicium. L'oxyde de silicium est ensuite dissout. La formation de la couche d'oxyde de silicium puis sa dissolution permettent de retirer la partie en surface du silicium qui comporte potentiellement des défauts et/ou amorces de fissure.

Une deuxième approche, décrite dans le document CH703445, consiste à appliquer à la pièce en silicium (c'est-à-dire à l'ébauche de composant horloger) issue de la gravure un traitement de recuit à une température de l'ordre de 1000°C en atmosphère réductrice. Selon ce document, le traitement de recuit a pour effet de faire migrer les atomes de silicium qui quittent les coins convexes (tels que les sommets des vaguelettes et les arêtes) et s'accumulent dans les coins concaves, ce qui conduirait à une réduction de la rugosité des flancs et à un arrondissement des arêtes.

D'autres approches utilisant une seconde gravure sont proposées dans les documents US2004/0232106 A1 et WO03/007026. Par ailleurs, le document "MEMS for a watches", Noell W et al, MICRO ELECTRO MECHANICAL SYSTEMS, 17TH IEEE INTERNATIONAL CONFER ENCE ON. (MEMS) MAASTRICHT, NETHERLANDS 25-29 JAN. 2004, décrit un procédé de fabrication d'un composant horloger selon le préambule de la revendication 1.

La présente invention propose une alternative aux approches précédemment proposés.

A cet effet, l'invention concerne un procédé de fabrication d'un composant horloger, dans lequel on réalise une pièce constituant une ébauche du composant horloger à partir d'un matériau micro-usinable, ladite pièce comportant au moins une surface présentant une rugosité initiale, caractérisé en ce qu'il comprend une étape de traitement de renforcement mécanique de la pièce par un fluide d'attaque destiné à diminuer la rugosité de ladite surface

L'appellation « fluide » doit ici être considérée au sens physique du terme. En physique, les « fluides » constituent un sous-ensemble de phases de la matière qui inclut les liquides, les gaz et les plasmas (et dans une certaine mesure certains solides plastique).

L'étape de traitement de renforcement mécanique de la pièce par un fluide d'attaque est de type isotrope.

Le procédé de l'invention offre l'avantage de ne pas nécessiter l'utilisation de températures élevées.

Le procédé comprend les étapes de :
- se munir d'un substrat dudit matériau micro-usinable ;
- recouvrir au moins partiellement le substrat d'un revêtement protecteur ménageant au moins une ouverture ;
- graver le substrat à travers l'ouverture du revêtement protecteur et obtenir ainsi une surface gravée ;
- appliquer le traitement de renforcement mécanique sur ladite surface gravée à travers l'ouverture du revêtement protecteur ;
- puis enlever le revêtement protecteur.

Les deux premières approches de l'art antérieur visent à réduire les défauts de surface sur les flancs de la pièce de silicium mais s'accompagnent d'effets potentiellement non souhaitables : les dimensions de la pièce sont sensiblement modifiées par la première approche et les arêtes sont arrondies par la deuxième approche.

Selon l'invention, le traitement d'attaque par un fluide est réalisé avec le revêtement protecteur encore présent sur la pièce. Grâce à cela, seules les surfaces gravées sont traitées et lissées de façon sélective, sans attaquer les surfaces recouvertes par le revêtement protecteur. Ce traitement sélectif de renforcement mécanique est mis en oeuvre de façon simple, sans étape supplémentaire, en réutilisant le revêtement protecteur déjà réalisé pour les besoins de la gravure. Ainsi, les surfaces protégées aux fins de la gravure (par exemple les surfaces du dessus et du dessous d'une plaquette de silicium qui peuvent être polies et avoir un aspect poli-miroir) ne sont pas attaquées par le traitement et ne risquent donc pas d'être endommagées par celui-ci. En outre, les arêtes ne sont pas arrondies par le traitement selon l'invention.

Le traitement de renforcement mécanique peut être un traitement par plasma ou par un liquide d'attaque chimique. Le plasma peut être formé à partir d'un gaz halogéné, notamment un gaz fluoré ou chloré. Dans ce cas, avantageusement, on polarise électriquement l'ébauche de composant durant le traitement par plasma. Grâce à cela, l'attaque par le plasma se concentre aux points où le champ électrique est le plus élevé, autrement dit sur les pointes et les protubérances faisant saillie en surface de la pièce. Cela a pour effet de lisser la rugosité de la surface.

Avantageusement, le procédé comprend tout ou partie des caractéristiques additionnelles suivantes :
- le plasma est formé à partir d'un gaz halogéné, notamment un gaz fluoré ou chloré ;
- on polarise électriquement la pièce durant le traitement par plasma ;
- le liquide d'attaque chimique comprend un acide ou une base, notamment de l'hydroxyde de potassium ou un mélange d'acides flurorhydrique, nitrique et/ou acétique ;
- on grave une ouverture à travers le substrat et on applique le traitement d'attaque au flanc de ladite ouverture du substrat ;
- on grave le substrat par gravure profonde, notamment par gravure ionique réactive profonde ou DRIE (« Deep Reactive Ion Etching ») ;
- le revêtement protecteur est en résine photosensible ou en oxyde de silicium ;
- on réalise l'ébauche de composant par une technique de type LIGA ou par un technique de découpe laser.

L'invention concerne aussi un composant horloger obtenu par le procédé de fabrication qui vient d'être défini, ainsi qu'une pièce d'horlogerie intégrant ce composant horloger.

L'invention sera mieux comprise à l'aide de la description suivante d'un mode de réalisation particulier du procédé de fabrication d'un composant horloger selon l'invention, et de variantes de réalisation, en référence aux dessins annexés sur lesquels :
- La figure 1 représente un équipement de traitement d'un composant horloger, pour la mise en oeuvre du procédé de l'invention, selon un mode de réalisation particulier ;
- La figure 2 représente un organigramme des étapes du procédé.

Le procédé de l'invention permet la fabrication de composants horlogers réalisés à partir d'un matériau micro-usinable et ayant des propriétés mécaniques renforcées. A titre d'exemples illustratifs et non limitatifs, ces composants peuvent être des roues dentées, des roues d'échappement, des aiguilles, des chevilles de plateau, des levées, des ressorts, notamment des ressorts de rappel ou des ressorts spiraux.

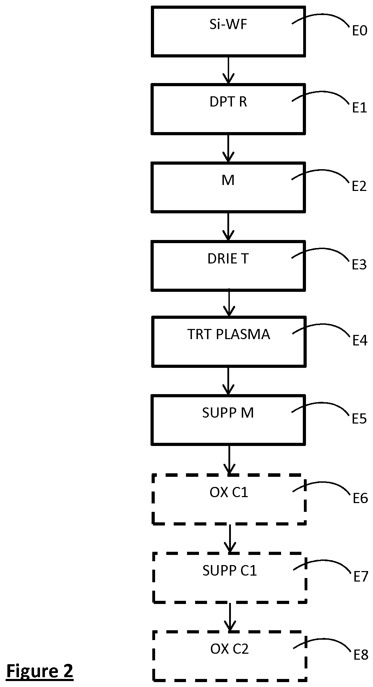

Sur la figure 2, on a représenté un organigramme des différentes étapes du procédé de fabrication d'un composant horloger, selon un premier mode de réalisation de l'invention.

Selon ce premier mode de réalisation, le procédé comprend une étape initiale E0 consistant à se munir d'un substrat en matériau micro-usinable. Le substrat est par exemple une plaquette (ou « wafer » selon la terminologie anglo-saxonne) de silicium, notée Si-WF. En variante, on pourrait utiliser à la place un substrat en quartz, en diamant ou en tout autre matériau micro-usinable adapté à la fabrication d'un composant horloger.

Lors d'une étape suivante E1, on recouvre d'un revêtement protecteur ici sur la totalité de la surface de la plaquette Si-WF, notamment sur ses deux faces dites supérieure et inférieure. En variante, on pourrait recouvrir seulement l'une des deux faces d'un revêtement protecteur, par exemple la face supérieure. Le revêtement protecteur R est ici en résine photosensible sur la face supérieure.

Le procédé se poursuit par une étape E2 de formation d'un motif de résine dans le revêtement protecteur R. Le motif de résine est réalisé en créant des ouvertures au travers de la couche de résine photosensible R. Le revêtement protecteur R ménageant des ouvertures constitue un masque de protection M. Les ouvertures peuvent être réalisées par insolation de la résine à travers un masque puis développement de la résine (c'est-à-dire dissolution, à l'aide d'un révélateur, des parties de résine exposées ou non exposées selon que la résine est positive ou négative). En variante, la résine peut être enlevée par une technique d'ablation laser ou par application d'un faisceau d'électrons suivie d'un développement.

L'étape E2 est suivie d'une étape E3 de gravure de la plaquette de silicium à travers le masque de protection M, ici par gravure ionique réactive profonde DRIE (« *Deep Reactive Ion Etching* » selon la terminologie anglo-saxonne). Lors de l'étape de gravure E3, on creuse un ou plusieurs trou(s) T, ou ouverture(s), dans le silicium Si-WF, au droit de la ou des ouverture(s) du masque M. Les trous gravés T sont réalisés préférentiellement à travers toute l'épaisseur de la plaquette Si-WF. On pourrait toutefois graver un ou plusieurs trou(s) borgne(s).

La technique de gravure DRIE est directionnelle. Elle opère en réalisant des cycles alternés d'attaque par plasma, pour creuser le fond de chaque trou T, et de dépôt d'une couche de protection sur les flancs nouvellement attaqués. Grâce à cela, l'attaque du silicium est dirigée de manière à réaliser un trou T qui s'étende uniquement au droit de chaque ouverture à travers le masque de protection M sans excavation au-dessous du masque. Cette alternance d'attaque par plasma et de dépôt d'une couche de protection sur les flancs crée à la surface de ceux-ci des défauts de planéité sous la forme de vaguelettes, appelés « scallops » en anglais, qui rendent la surface rugueuse.

L'étape de gravure E3 est suivie d'une étape E4 de traitement de renforcement mécanique de la pièce de silicium issue de la gravure, cette pièce constituant une ébauche de composant horloger. Le traitement de renforcement mécanique consiste en un traitement d'attaque par un fluide des surfaces gravées à l'étape précédente E3, en l'espèce les flancs des trous creusés par gravure.

Dans le mode de réalisation décrit ici, le traitement d'attaque des flancs s'effectue par plasma. Le plasma peut être formé à partir d'un gaz halogéné tel qu'un gaz fluoré (par exemple NF3, CF4 ou SF6) ou un gaz chloré. Il peut également comprendre un gaz de dilution non réactif, tel que l'hélium ou l'argon.

En outre, durant le traitement par plasma, le substrat en silicium est ici polarisé électriquement. La polarisation du silicium permet de concentrer l'attaque par plasma aux points où le champ électrique est le plus élevé, autrement dit sur les pointes et les protubérances faisant saillie en surface de la pièce.

Les conditions et paramètres de traitement par plasma, par exemple un plasma formé à partir d'un gaz contenant du SF6, peuvent être les suivantes :
- gaz contenant entre 10% et 85% en volume de SF6 ;
- flux de gaz ayant un débit compris entre 1 et 200 sccm ;
- pression de gaz dans la chambre comprise entre 0.1 Pa et 5Pa ;
- puissance de source plasma comprise entre 500W et 3000W ;
- polarisation du substrat comprise entre -10 V et -40 V ;
- température du substrat comprise entre 20°C et 120°C et
- temps de traitement compris entre 30s et 300s.

Le traitement par plasma a pour effet de lisser les flancs des trous gravés et donc de diminuer leur rugosité. La polarisation du substrat renforce encore l'effet lissant du traitement par plasma. Les défauts de planéité des flancs des trous gravés étant ainsi fortement réduits, voire éliminés, il en résulte un renforcement des propriétés mécaniques de la pièce en silicium, notamment de sa résistance mécanique. En outre, les propriétés de frottement tribologique des surfaces traitées sont améliorées.

En remarque, le traitement par plasma implémenté présente aussi la caractéristique d'être une gravure isotrope. Cette caractéristique induit une vitesse d'attaque égale quelle que soit l'orientation des plans de la surface à lisser. En présence de composants qui n'ont pas de faces planes, cela permet d'atteindre un résultat homogène et satisfaisant, même si le temps d'attaque est court.

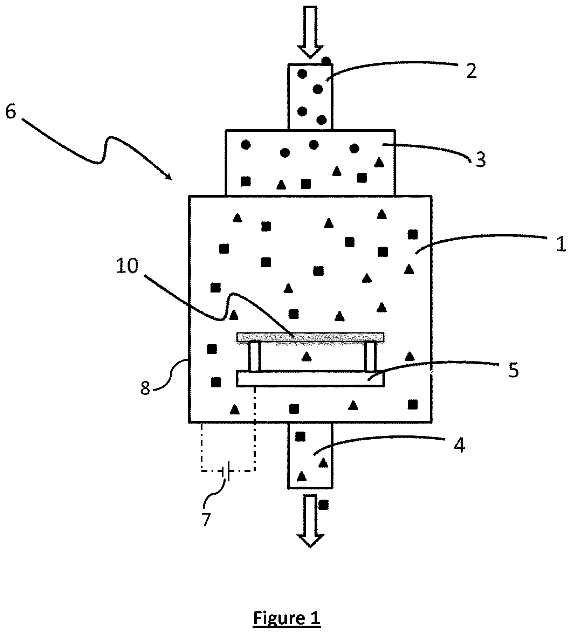

Sur la figure 1, on a représenté un équipement de traitement pour réaliser le traitement plasma de lissage. L'équipement 6 comprend une chambre de réaction 1 qui est délimitée par une enceinte 8. La chambre 1 est reliée à une entrée d'un gaz précurseur 2, représenté par des ronds, par l'intermédiaire d'une chambre ICP 3 (de l'anglais « *inductively coupled plasma* » - plasma couplé par induction) destinée à produire des ions et des radicaux, respectivement représentés par des triangles et des carrés, à partir du gaz précurseur. La chambre 1 comporte également une sortie de pompage 4, à travers laquelle les ions et les radicaux sont évacués de la chambre 1. Un support 5 destiné à supporter la pièce à traiter est disposé dans la chambre 1. Le support 5 est relié à un générateur électrique de tension 7, également relié à l'enceinte 8, comme représenté sur la figure 1. Le générateur 7 permet ainsi de polariser la pièce à traiter posée sur le support 5.

Le traitement de renforcement mécanique est réalisé avec le masque de protection M qui est encore présent sur le substrat en silicium. Grâce à cela, le traitement est sélectif, c'est-à-dire qu'il s'applique uniquement aux surfaces non recouvertes par la résine. Ainsi, les flancs des ouvertures gravées sont lissés de façon sélective. Les surfaces recouvertes par la résine restent protégées et ne risquent pas d'être endommagées par le traitement par plasma, qui est potentiellement susceptible d'altérer sensiblement leur aspect. C'est le cas notamment dans le cas où les surfaces présentent un aspect poli-miroir. De telles surfaces seraient légèrement endommagées par le traitement plasma de renforcement mécanique. Le revêtement protecteur en résine permet de garder ces surfaces parfaitement intactes. En outre, le caractère sélectif du traitement permet de ne pas créer de chanfrein ou d'arrondi entre la face supérieure de la pièce et les flancs des ouvertures à travers le silicium.

Un autre avantage du procédé est qu'il permet, après l'étape de traitement E4 de lissage et de renforcement mécanique, de déposer des couches supplémentaires, de façon sélective, seulement sur les flancs, sans qu'il soit nécessaire de réaliser d'étape supplémentaire de masquage sélectif des surfaces supérieure et/ou inférieure de la pièce. De surcroît, l'adhésion d'un tel dépôt est renforcée grâce à la diminution de la rugosité obtenue à l'issue de l'étape E4.

Le procédé se poursuit par une étape E5 d'enlèvement du masque M, de façon classique, par dissolution de la résine.

Après avoir enlevé la résine, le procédé peut optionnellement comprendre une double oxydation thermique, réalisée par des étapes E6 à E8. Lors de l'étape E6, une première couche C1 d'oxyde de silicium SiO₂ est formée par oxydation thermique en surface du silicium, sur toute la pièce issue de l'étape E5 d'enlèvement de résine. Lors de l'étape E7, la couche d'oxydation C1 est retirée par attaque chimique, par exemple à l'aide d'une solution d'acide fluorhydrique. Puis, lors de l'étape E8, une deuxième couche C2 d'oxyde de silicium est formée par oxydation thermique en surface du silicium sur toute la pièce telle qu'issue de l'étape précédente E7. La formation de la première couche d'oxyde C1 puis son élimination permettent d'éliminer les défauts de surface initialement présents dans la partie du silicium qui est convertie en oxyde de silicium lors de l'étape E6. La formation de la deuxième couche d'oxyde C2 permet de supprimer encore davantage de défauts de surface. En effet, la conversion en surface de silicium en oxyde de silicium permet, le cas échéant, de faire disparaître des micro-ouvertures superficielles et de colmater des microfissures.

A la place d'une double oxydation, on pourrait réaliser seulement les étapes E6 et E7 d'oxydation et d'élimination de la couche d'oxyde, voire seulement l'étape d'oxydation E6.

A la place du plasma, l'étape de renforcement mécanique E4 peut utiliser un fluide d'attaque chimique, notamment un liquide, comportant une base ou un acide. On utilise des fluides agissant de manière isotrope comme les mélanges à base d'acide fluorhydrique (mélange « HNA »), de manière à s'affranchir du caractère anisotrope des attaques réalisées avec par exemple l'hydroxyde de potassium (« KOH ») ou l'hydroxyde de tetraméthylammonium (« TMAH »).

En effet, en cas d'implémentation d'une attaque de type anisotrope, il existe un risque de modifier microscopiquement la géométrie du composant telle qu'elle est définie par le masque, en raison des vitesses d'attaque différentes entre les différents plans du silicium. Des micro-gravures initialement circulaires peuvent ainsi devenir rectangulaires.

Lors de l'étape E4, la pièce à traiter issue de l'étape E3 peut être immergée dans un bain comportant l'un de ces fluides d'attaques pendant une durée prédéfinie.

Ces fluides d'attaque chimique permettent d'attaquer directement les surfaces nues de silicium, à savoir les flancs des ouvertures gravées, et de lisser ces surfaces nues par voie d'attaque chimique. La nature du revêtement protecteur R est adaptée au liquide d'attaque chimique utilisé. En toute hypothèse, l'épaisseur du revêtement R et la durée de l'immersion dans le bain de liquide d'attaque chimique sont adaptés pour que le revêtement protecteur assure une protection efficace des surfaces couvertes pendant toute la durée du traitement d'attaque.

Dans la description qui précède, l'étape E4 de traitement de renforcement mécanique de la pièce de silicium est réalisée avant enlèvement du revêtement protecteur.

Le revêtement protecteur pourrait être réalisé en oxyde de silicium SiO₂, à la place de la résine photosensible.

Selon une variante qui ne fait pas partie de l'invention, le traitement de renforcement mécanique (étape E4) pourrait être appliqué à des pièces (composants horlogers ou ébauches de composant horloger) réalisées par une technique autre que la gravure, par exemple par une technique de type LIGA ou par une technique de découpe laser. Dans le cas d'une pièce fabriquée par LIGA à partir d'un moule en résine, l'attaque par plasma (ou par un fluide d'attaque chimique) permettrait de lisser les surfaces de la pièce ayant été en contact avec le moule de résine. Dans le cas d'une pièce fabriquée par découpe laser, l'attaque par plasma (ou par un fluide d'attaque chimique) permettrait de lisser les surfaces découpées au laser.

L'invention concerne aussi un composant horloger fabriqué selon le procédé de fabrication qui vient d'être décrit, ainsi qu'une pièce d'horlogerie intégrant ce composant horloger.

## Revendications

1. Procédé de fabrication d'un composant horloger, dans lequel on réalise une pièce constituant une ébauche du composant horloger à partir d'un matériau micro-usinable, ladite pièce comportant au moins une surface présentant une rugosité initiale, ce procédé comprenant les étapes de :
• se munir (E0) d'un substrat dudit matériau micro-usinable ;
• recouvrir (E1-E2) au moins partiellement le substrat d'un revêtement protecteur ménageant au moins une ouverture ;
• graver (E3) le substrat à travers l'ouverture du revêtement protecteur et obtenir ainsi une surface gravée ;
et **caractérisé en ce qu'**il comprend une étape (E4) de :
• traitement de renforcement mécanique de la pièce par un fluide d'attaque isotrope destiné à diminuer la rugosité de ladite surface, le traitement de renforcement mécanique étant appliqué sur ladite surface gravée à travers l'ouverture du revêtement protecteur ; puis **en ce qu'**il comprend une étape consistant à enlever (E5) le revêtement protecteur.

2. Procédé selon la revendication précédente, **caractérisé en ce que** le traitement de renforcement mécanique (E4) est un traitement par plasma ou par un liquide d'attaque chimique.

3. Procédé selon la revendication précédente, **caractérisé en ce que** le plasma est formé à partir d'un gaz halogéné, notamment un gaz fluoré ou chloré.

4. Procédé selon l'une des revendications 2 et 3, **caractérisé en ce qu'**on polarise électriquement la pièce durant le traitement par plasma.

5. Procédé selon la revendication 2, **caractérisé en ce que** le liquide d'attaque chimique comprend un acide ou une base, notamment un mélange d'acides flurorhydrique, nitrique et/ou acétique.

6. Procédé selon l'une des revendications précédentes, **caractérisé en ce qu'**on grave une ouverture à travers le substrat et on applique le traitement d'attaque au flanc de ladite ouverture du substrat.

7. Procédé selon l'une des revendications précédentes, **caractérisé en ce qu'**on grave le substrat par gravure profonde, notamment par gravure ionique réactive profonde ou DRIE (« Deep Reactive Ion Etching »).

8. Procédé selon l'une des revendications précédentes, **caractérisé en ce que** le revêtement protecteur est en résine photosensible ou en oxyde de silicium.

9. Procédé selon la revendication 1, **caractérisé en ce qu'**on réalise l'ébauche de composant par une technique de type LIGA ou par un technique de découpe laser.

10. Procédé selon l'une des revendications précédentes, **caractérisé en ce que** le matériau micro-usinable est l'un des matériaux du groupe comportant du silicium, du diamant et du quartz.

11. Procédé selon l'une des revendications précédentes, **caractérisé en ce que** le composant horloger est l'un des éléments du groupe comportant une roue dentée, une roue d'échappement, une aiguille, une cheville de plateau, une levée, un ressort, notamment un ressort de rappel ou un ressort spiral.

12. Composant horloger obtenu par le procédé de fabrication selon l'une des revendications 1 à 11.

13. Pièce d'horlogerie comportant un composant horloger selon la revendication 12.

## Patentansprüche

1. Herstellungsverfahren für eine Uhrenkomponente, bei welchem man ein Teil erstellt, das einen Rohling der Uhrenkomponente bildet anhand eines mikro-bearbeitbaren Materials, wobei das genannte Teil wenigstens eine Oberfläche umfasst, die eine Anfangsrauigkeit aufweist, wobei das Verfahren die folgenden Schritte umfasst:
- ein Substrat für das genannte mikro-bearbeitbare Material bereitstellen (E0);
- das Substrat wenigstens teilweise mit einer schützenden Beschichtung bedecken (E1-E2), wobei wenigstens eine Öffnung vorgesehen wird;
- das Substrat durch die Öffnung der schützenden Beschichtung hindurch gravieren (E3) und somit eine gravierte Oberfläche erhalten;
und **dadurch gekennzeichnet, dass** es einen Schritt (E4) aufweist:
- Behandlung zur mechanischen Verstärkung des Teils durch eine isotrope Ätzmittelflüssigkeit, welche dazu vorgesehen ist, die Rauigkeit der genannten Oberfläche zu mindern, wobei die Behandlung zur mechanischen Verstärkung auf der gravierten Oberfläche durch die Öffnung in der schützenden Beschichtung vorgenommen wird; sodann, dass es einen Schritt (E5) umfasst, der darin besteht, die schützende Beschichtung abzunehmen,

2. Verfahren gemäß dem vorangehenden Anspruch, **dadurch gekennzeichnet, dass** die Behandlung zur mechanischen Verstärkung (E4) eine Behandlung durch Plasma oder durch eine chemische Ätzmittelflüssigkeit ist.

3. Verfahren gemäß dem vorangehenden Anspruch, **dadurch gekennzeichnet, dass** das Plasma ausgehend von einem Halogengas gebildet wird, insbesondere ein Fluoriertes oder ein chloriertes Gas.

4. Verfahren gemäß einem der Ansprüche 2 und 3, **dadurch gekennzeichnet, dass** man das Teil während der Plasmabehandlung elektrisch polarisiert.

5. Verfahren gemäß Anspruch 2, **dadurch gekennzeichnet, dass** die chemische Ätzmittelflüssigkeit eine Säure oder eine Base umfasst, insbesondere eine Mischung aus Fluorwasserstoffsäuren, Salpetersäuren und/oder Essigsäuren.

6. Verfahren gemäß einem der vorangehenden Ansprüche, **dadurch gekennzeichnet, dass** eine Öffnung durch das Substrat graviert wird und dass man die Ätzbehandlung an der Seitenwand der genannten Öffnung des Substrats durchführt.

7. Verfahren gemäß einem der vorangehenden Ansprüche, **dadurch gekennzeichnet, dass** man das Substrat mit einer Tiefengravur graviert, insbesondere über ein reaktives lonenätzverfahren oder DRIE ("Deep Reactive Ion Etching").

8. Verfahren gemäß einem der vorangehenden Ansprüche, **dadurch gekennzeichnet, dass** die schützende Beschichtung aus lichtempfindlichem Harz oder aus Siliziumoxid besteht.

9. Verfahren gemäß Anspruch 1, **dadurch gekennzeichnet, dass** der Rohling des Bauteils durch eine LIGA Technik oder durch ein Laserschneidverfahren erstellt wird.

10. Verfahren gemäß einem der vorangehenden Ansprüche, **dadurch gekennzeichnet, dass** das mikro-bearbeitbare Material ein Material aus der Gruppe umfassend Silizium, Diamant und Quarz ist.

11. Verfahren gemäß einem der vorangehenden Ansprüche, **dadurch gekennzeichnet, dass** die Uhrenkomponente ein Element ist aus der Gruppe umfassend ein Zahnrad, ein Zeiger, eine Hebescheibe, ein Ankerstein, eine Feder, insbesondere eine Rückholfeder oder eine Spiralfeder.

12. Uhrenkomponente, erhalten durch das Herstellungsverfahren gemäß einem der Ansprüche 1 bis 11.

13. Uhr, umfassend eine Uhrenkomponente gemäß Anspruch 12.

## Claims

1. A process for manufacturing a timepiece component, wherein a part forming a blank of the timepiece component is produced from a micromachinable material, said part comprising at least one surface having an initial roughness, **characterized in that** ir comprises the steps of :
• providing (E0) a substrate of said micromachinable material;
• at least partially covering (E1-E2) the substrate with a protective coating containing at least one aperture;
• etching (E3) the substrate through the aperture in the protective coating and thus obtaining an etched surface;
• and **in that** it comprises a step of (E4) of mechanically strengthening treatment of the part by an isotropic etching fluid intended to decrease the roughness of said surface, the mechanically strengthening treatment being applied to said etched surface through the aperture in the protective coating; and **in that** it comprises then a step consisting of removing (E5) the protective coating.

2. The process as claimed in the preceding claim, **characterized in that** the mechanically strengthening treatment (E4) is a plasma treatment or a treatment with a liquid chemical etchant.

3. The process as claimed in the preceding claim, **characterized in that** the plasma is formed from a halogen-containing gas, especially a fluorine- or chlorine-containing gas.

4. The process as claimed in one of claims 2 and 3, **characterized in that** the part is electrically biased during the plasma treatment.

5. The process as claimed in claim 2, **characterized in that** the liquid chemical etchant comprises an acid or a base, especially a mixture of hydrofluoric, nitric and/or acetic acids.

6. The process as claimed in one of the preceding claims, **characterized in that** an aperture is etched through the substrate and the etching treatment is applied to the sidewall of said aperture in the substrate.

7. The process as claimed in one of the preceding claims, **characterized in that** the substrate is etched by deep etching, especially by deep reactive ion etching (DRIE).

8. The process as claimed in one of the preceding claims, **characterized in that** the protective coating is made of photoresist or of silicon oxide.

9. The process as claimed in claim 1, **characterized in that** the component blank is produced using a LIGA technique or using a laser cutting technique.

10. The process as claimed in one of the preceding claims, **characterized in that** the micromachinable material is one of the materials from the group comprising silicon, diamond and quartz.

11. The process as claimed in one of the preceding claims, **characterized in that** the timepiece component is one of the elements from the group comprising a toothed wheel, an escapement wheel, a hand, an impulse pin, a pallet and a spring, especially a return spring or a balance spring.

12. A timepiece component obtained by the manufacturing process as claimed in one of claims 1 to 11.

13. A timepiece comprising a timepiece component as claimed in claim 12.
